# EUROPEAN PATENT APPLICATION

(11) **EP 0 849 800 A1**
(43) Date of publication of application: **24.06.1998**
(21) Application number: 96830639.9
(22) Date of filing: 20.12.1996
(51) Int. Cl.: H01L 25/065, H01L 23/538

(54) **Multichip module with differently packaged integrated circuits and method of manufacturing it**

(71) Applicant: BULL HN INFORMATION SYSTEMS ITALIA S.p.A., 10014 Caluso (Torino) (IT)
(72) Inventor: Di Ianni, Marianna, 20017 Rho (Milano) (IT); Melloni, Paolo, 22060 Carimate (Como) (IT)
(74) Representative: Perani, Aurelio

(57) **Abstract**

In order to reduce the encumbrance of the set, the lenght of the connections and to achieve high performances without giving up testability of the product, the interchangeability and evolution of the used components, a multichip module having more chips on a ceramic substrate (1) is obtained by bonding at least a bare integrated circuit die (12), for example a microprocessor, to the ceramic substrate (1), testing the set so assembled, then adding, with a subsequent bonding operation, a plurality of electronic components (13,14,..21,22) packaged in surface mounting containers and pre-tested, for example static memories performing as cache for the microprocessor.

## Description

The present invention relates to a multichip module having a mixed assembly and packaging tecnology and the related manufacturing process, in particular a multichip module hosting on the same substrate a bare microprocessor die and a plurality of packaged static memory integrated circuits so as to form a processor with high capacity cache memory and high processor performances.

For implementing processors with a large capacity cache (which cannot be obtained in the same integrated circuit die which constitutes the processor) the current technology offers two alternatives:

### 1) Standard MCM (multichip module) technology with bare dice.

This technology allows for the best integration due to the possibility to assembly the bare dice as close as possible on a ceramic substrate which ensures a strict flatness and the reliable implementation of weldings by the technique known as flip chip bonding.

With a so close assembly, the lenght of the connection leads and the related impedance are kept to a minimum.

Consequently the switching and propagation time of the signals among the components is reduced.

However this technology has heavy trade offs at manufacturing and testing level.

### Testability

If the MCM hosts VLSI microprocessor like and memory chips it is practically impossible to jointly test in high frequency the microprocessor and the the memory chips.

This for two reasons:
- the testing times would be so long as to be unfeasible, due to the interaction between microprocessor and the memories,
- it would be difficult and in some cases impossible to locate possible failure or defects. For example an open circuit could be due both to the defective bonding of a microprocessor terminal as well as of the terminal of a memory component.

On the other hand the thermocompression bonding operation may cause unrecoverable damages of the components, so that the quality and the functionality of the module cannot be ensured by the use of bare individually tested dice, whose testing in high frequency is particularly difficult, if not impossible, at bare die level.

### Procurement/design evolution

The procurement and design problems come from the need of a change of design in the topography (layout) and connections of the ceramic substrate each time that the design of the dice change or it is desired to use a new vendor.

For example in the case of memory chips, the chip design evolves with extreme rapidity and the layout of the pads for external connection changes in the time and from vendor to vendor.

Interchangeability is ensured only at the level of packaged dice, as well as their functionality at high frequency.

On the other hand the second sourcing availability for the same component is a competition key factor to keep down procurement costs.

This possibility is virtually excluded if, as a prerequisite, it requires the substrate redesign, with technical times for execution, testing, and manufacturing start-up which are not negligible and with costs which frustrate the saving achievable at procurement level.

### Reparability

Even if the bonding technology is well established and relatively reliable, the assembly yield, at module level, is not satisfactory and the module reparability, by replacement of a possible defective bare die is not so easy to do. The result is that it is not possible to guarantee a high volume production at reasonable costs.
So the MCM standard technology is not an economically valid solution to the problem of integrating memories and a microprocessor on a substrate.

### 2) Standard SMT technology with dice packaged in containers having rheophores or terminals for surface mounting.

By this technology, the several integrated circuit dice, previously packaged and individually high frequency tested, are bonded on a supporting printed circuit board.

The packaging, which complies with a standardised layout of the connection leads, followed by the different manufacurers and invariant with the die design, ensures the vendor interchangeability and the component evolution, without need of common substrate redesign.

Testability of the assembled module may be limited to the quality test of the performed connection bonding, with low frequency measurement of conductivity and isolation.

Reparability is easy to do.

Thus the several problems of testability, procurement, design evolution, reparability are under control, but the integration of several components on the module is a critical factor, due to the packages and connectors dimensions.

Clearly the greater lenght of the conductors and their larger size have a relevant impact on the achievable performances.

The above mentioned disadvantages and the prior art limitations are overcome by the mixed technology which is the subject of the present invention, which allows for implementation of multichip modules where a ceramic substrate is a support for a microprocessor bare die and for a plurality of memory chips, each packaged in its own container.

Advantageosly the memory chip packaging is of the kind known with the acronym BGA (Ball Grid Array) for surface mounting (therfore it is a SMT technology) by means of connection balls arranged in a standardised grid of 17x7 elements, defined by an international organization (JEDEC).

In this way the several components may be placed in close proximity each to the other with connection conductors having reduced lenght and impedance.

Additionally the manufacturing process which provides first the bonding of the microprocessor bare die on the substrate and only subsequently the bonding of the memory components, already tested, allows to perform in an easy way, even during intermediate phases of the process, all the required tests to ensure the module functionality and its quality.

In summary, the following advantages are achieved.

The same function, in the given specific example a processor with an high capacity cache, may be built in a module of reduced size, compared to functionally equivalent modules built up in PCB-SMT technology (printed circuit board, surface mounting packaged circuits).

Testability improvement are two-fold:
packaged chip (memories) can be processed in a standard test and burn-in, before their bonding on the substrate, so avoiding frequent infant mortality of this kind of chips.

The tests may be performed in high frequency, thus checking the speed performance of the components.

The bare die (or dice, if more than one) is first mounted on the ceramic target substrate and high frequency tested in a traditional fashion by means of external interconnect and pads of the substrate in connection with the metalised footprint of the bare die.

Then the packaged dice, whose functionality and performances have been already tested, are surface mounted on the target substrate.

Therefore it suffices, as a further test, to check the quality of the electrical commections, by means of electrical measurements which may be performed in low frequency, through JTAG test interfaces of which the integrated circuits of some complexity are normally provided or even by performing, in case of memory components, a limited number of read/write operations with data having a predetermined pattern.

The procurement of packaged components, which at package level must comply with predetermined standards in the arrangement of the connection leads, is made independent of the vendors, who also ensure the compatibility of the several manufacturing batches in case of product evolution at the level of silicon technology and process masks.

The features and the advantages of the present invention will appear more clearly from the following description of a preferred embodiment of multi-chip module given with reference to the enclosed drawings where:
- figure 1 is a perspective, exploded view of a multichip module bearing integrated circuits with mixed assembling and packaging technology, made in accordance with the present invention,
- figure 2 is a perspective view of the module of figure 1, once assembled,
- figure 3 shows in plan view the lower face of the module of figures 1 and 2, which is not visible in the preceding figures.

With reference to the drawings, a module implemented in accordance with the present invention comprises a rectangular ceramic substrate having, indicatively a size of 63,5x51x2,7mm.

The ceramic substrate, per se conventional, implemented in HTCC technology (High Temperature Cofired Ceramic) is composed of a plurality (15) of thin ceramic sheets, on whose faces layers of conductive material are laid down, with known serigraphic technologies, to form conductive interconnection elements.

Interconnection among the several layers is provided by holes filled with conductive material.

The set of sheets is then stacked and high temperature sintered.

On the external faces of the substrate, upper and lower respectively, pads for connection to the components intended for mounting on the substrate, as well as pads for connection of the module to external components, are gold plated.

These last may be replaced with connection pins for coupling with female connectors.

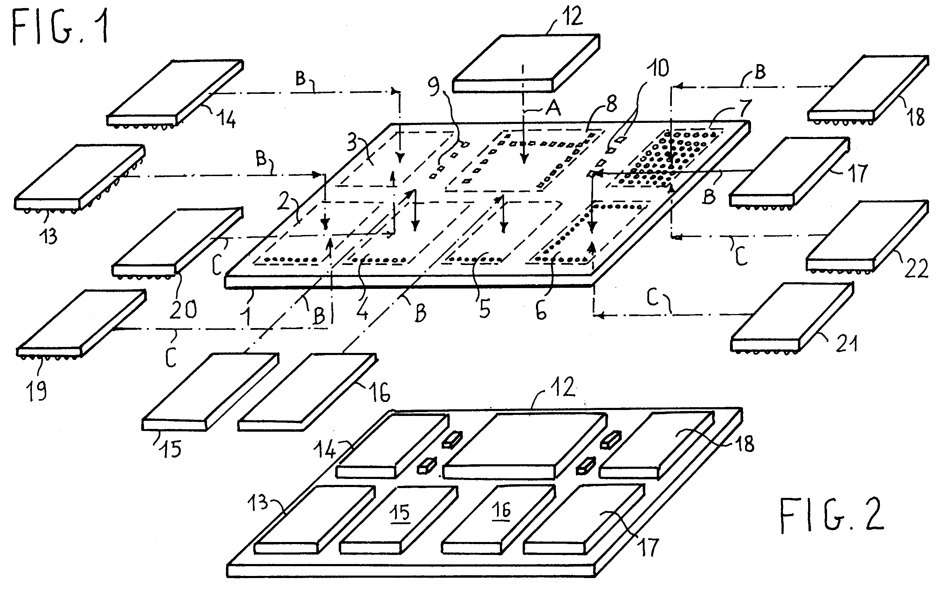

In figure 1 it may be seen, on the upper face of the substrate, a plurality of sets of connection pads 2,3,4,5,6,7,8, respectively intended for connection to memory components (from 2 to 7) and for connection to a microprocessor bare die (set 8).

Located among the several pad sets, pad rows 9,10 may be seen, intended for connection to resistors and/or decoupling capacitors.

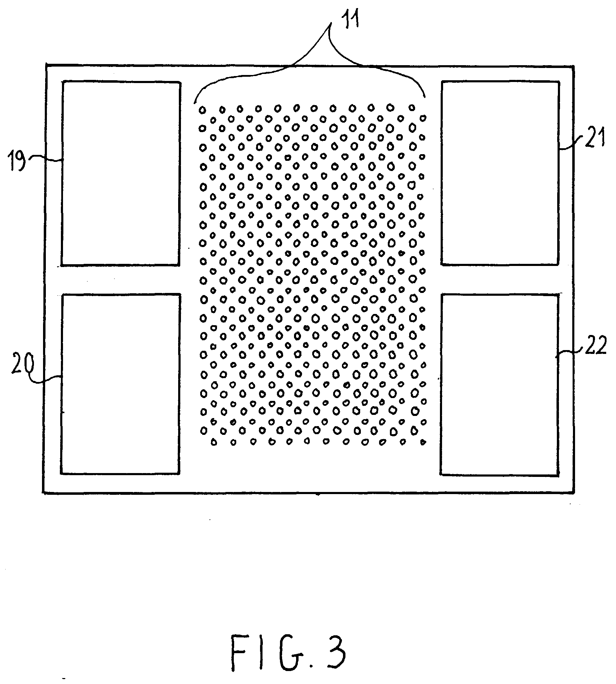

With reference to figure 3, in the central portion of the substrate a set of pads or pins 11, for example in number of 12x18x2, may be seen, for connection of the module with the outside and, obviously, for its powering.

The assembling process of the module comprises the following phases: in a first phase (step A of Fig.1) a bare microprocessor die 12 is mounted on the substrate 1, with the technique known as flip chip bonding, on the area defined by the pad set 8.

Once reflow soldering is performed, it is possible to use the pad set 11 (Fig. 3) and, if required, the other pad sets too, to test the functionality, even at high frequency, of the processor installed in the module and the quality of the performed reflow bonding, with a test bed of a conventional type.

In a second phase (step B of Fig.1) the several memory components, consisting in packaged dice 13,14,15,16,17,18, of the BGA type, are bonded each respectively on an area defined by one of the pad sets 2,3,4,5,6,7.

These components do not need to be tested because their test has been previously performed, in case during their procurement and income acceptance.

Resistive and capacitive surface mounting components, not shown, may be soldered on pad rows 9,10 of the substrate, in the same phase.

In a third phase (step C of Fig. 1) further memory components, still packaged in BGA type containers, are bonded on the lower surface of the ceramic substrate.

At this point, the assembled module may be tested with conventional test procedures which use the terminals for connection with the outside, to test the quality of the bonds and the overall functionality of the module, in case with the aid of JTAG test interfaces which allows to output from the module, the status of internal elements which are not directly accessible for measurement.

Both static RAM memories having capacity of 64K x18 bit as well as static RAMs having capacity of 256K x 18 bit, packaged in BGA 17x7 packages are commercially available.

It is therefore clear that the described module may perform the function of a processor with external cache having a capacity of 1 Mbyte or 4 Mbyte, without excluding the possibility of implementing caches of a lower capacity, with the limits of read/write parallelism imposed by the system to the cache.

Although the preceding description refers to a multichip module which implements the function of a processing unit with external cache, it is clear that the same inventive concept may be used to implement multichip modules having different functionalities, for example processing units coupled to I/O (input/output) controllers for information transfer at very high speed, by way of example on optical fiber, and generally in all these cases where it is required to keep to a minimun the size of the equipment without giving up the opportunity to use pre-tested components, fast evolving at silicon technology level and supplied by several competing vendors.

## Claims

1. Multichip module where at least an integrated circuit bare die (12) is muunted on a ceramic substrate (1) with the flip chip bonding technology, characterised in that it comprises, on the same substrate (1) a plurality of electronic integrated circuit components (13,14,..22) packaged in surface mounting containers and pre-tested.

2. Multichip module as in claim 1, where said bare die (12) is a microprocessor die and said electronic integrated circuit components (13,14,..22) are static memories packaged in Ball Grid Array type containers.

3. A method of manufacturing a multichip module bearing mixed technology integrated circuits characterised by the following ordered steps:
- bonding of a bare integrated circuit die (12) to a ceramic substrate (1), with the flip chip bonding technique,
- high frequency testing of the integrated circuit (12) bonded to the ceramic substrate (1) by applying test stimulations through interconnection terminals of the substrate with the outside,
- bonding to said ceramic substrate (1) a plurality of electronic integrated circuit components, packaged in surface mounting containers and pre-tested.
